# EUROPÄISCHE PATENTANMELDUNG

(11) **EP 4 563 555 A1**
(43) Veröffentlichungstag der Anmeldung: **04.06.2025**
(21) Anmeldenummer: 24214379.0
(22) Anmeldetag: 21.11.2024
(51) Int. Cl.: C04B 37/02, C04B 41/53, H01L 21/306, C04B 41/00

(54) **METALL-KERAMIK-VERBUND**

(30) Priorität: 30.11.2023 EP 23213371
(71) Anmelder: Heraeus Electronics GmbH & Co. KG, 63450 Hanau (DE)
(72) Erfinder: Wacker, Richard, 63450 Hanau (DE); Niewolak, Leszek, 63450 Hanau (DE); Stoica, Stefanie, 63450 Hanau (DE); Schlüter, Bastian, 63450 Hanau (DE); Schnee, Daniel, 63450 Hanau (DE)
(74) Vertreter: Heraeus IP

(57) **Zusammenfassung**

Die vorliegende Erfindung betrifft einen Metall-Keramik-Verbund, enthaltend
ein Keramiksubstrat, das eine Vorderseite und eine Rückseite aufweist und ein Siliziumnitrid enthält,
eine auf der Vorderseite des Keramiksubstrats vorliegende Metallbeschichtung, wobei die Metallbeschichtung zumindest eine Aussparung aufweist und eine Oberfläche des Keramiksubstrats durch die Aussparung freigelegt ist,
wobei die durch die Aussparung freigelegte Oberfläche des Keramiksubstrats ein gestrecktes Oberflächenverhältnis S_{dr} gemäß der Norm ILNAS-EN ISO 25178-2:2022 von mindestens 7,0 % aufweist, wobei S_{dr} durch Konfokalmikroskopie bestimmt wird.

## Beschreibung

Die vorliegende Erfindung betrifft einen Metall-Keramik-Verbund, der als keramischer Schaltungsträger in der Leistungselektronik verwendbar ist.

In der Leistungselektronik müssen Leiterplatten als Träger von Leistungsbauteilen wie MOSFETs für hohe Ströme ausgelegt sein und Verlustwärme schnell abführen können.

Da keramische Materialien wie Aluminiumoxid, Aluminiumnitrid und Siliziumnitrid gegenüber Polymeren, die für die Herstellung herkömmlicher Leiterplatten verwendet werden, eine wesentlich höhere Wärmeleitfähigkeit aufweisen, werden in Leistungsmodulen häufig keramische Schaltungsträger verwendet.

Keramiksubstrate auf der Basis von Siliziumnitrid weisen eine sehr hohe mechanische Festigkeit bei gleichzeitig hoher Wärmeleitfähigkeit auf und sind daher sehr gut für Anwendungen in der Leistungselektronik geeignet.

Keramiksubstrate auf der Basis von Siliziumnitrid werden beispielsweise in folgenden Publikationen beschrieben:
N. Chasserio et al., "Ceramic Substrates for High-Temperature Electronic Integration", Journal of Electronic Materials, Band 38 (2009), S. 164-174;
K. Hirao et al., "High Thermal Conductivity Silicon Nitride Ceramics", Journal of the Korean Ceramic Society, Band 49 (2012), S. 380-384;
Y. Zhou et al., "Development of high-thermal-conductivity silicon nitride ceramics", Journal of Asian Ceramic Societies, 3 (2015), S. 221-229.

Siliziumnitridbasierte Keramiksubstrate, die einen guten Kompromiss zwischen hoher mechanischer Festigkeit und hoher Wärmeleitfähigkeit zeigen und in elektronischen Bauteilen verwendet werden können, sind kommerziell erhältlich.

Ein keramischer Schaltungsträger enthält ein Keramiksubstrat, das zumindest auf einer seiner Seiten, üblicherweise beidseitig mit einer Metallschicht versehen ist. Auf einer dieser Metallschichten sind im finalen Modul die Halbleiterbauelemente aufgebracht, während die Metallschicht auf der gegenüberliegenden Seite des Keramiksubstrats thermisch leitend mit einem Kühlkörper verbunden ist. Durch das Keramiksubstrat sind die Metallschichten elektrisch isoliert voneinander.

Die dem Fachmann bekannte Herstellung eines als keramische Leiterplatte fungierenden metallisierten Keramiksubstrats erfolgt beispielsweise, indem die Vorder- und Rückseite des Keramiksubstrats jeweils mit einer Metallfolie (z.B. einer Kupfer- oder Aluminiumfolie) in Kontakt gebracht und stoffschlüssig verbunden werden. Das stoffschlüssige Verbinden der Metallfolien erfolgt beispielsweise über ein eutektisches Bonden oder ein Aktivlöten (englisch: *"active metal brazing",* AMB). Ist die Metallfolie eine Kupferfolie, so wird das eutektische Bonding auch als DCB- oder DBC-Verfahren bezeichnet (DCB: *"Direct Copper Bonding";* DBC: *"Direct Bonded Copper"*). Im Fall einer Aluminiumfolie wird beim eutektischen Bonding auch die Bezeichnung "DAB" (*"Direct Aluminum Bonding*") verwendet. Ein über ein DCB- oder AMB-Verfahren hergestelltes metallisiertes Keramiksubstrat wird gelegentlich auch als DCB-Substrat (alternativ: DBC-Substrat) oder AMB-Substrat bezeichnet.

Die Metallisierung von Siliziumnitridsubstraten erfolgt üblicherweise durch ein Aktivlöten.

Aktivlote enthalten neben einer Hauptkomponente wie z.B. Cu, Ag oder Au ein oder mehrere Elemente, die mit der Keramik unter Ausbildung einer haftvermittelnden Reaktionsschicht reagieren können (siehe z.B. Kapitel 8.2.4.3 ("Aktivlöten"), Seiten 203-204, in Brevier Technische Keramik, Verband der Keramischen Industrie e.V., 2003, Fahner Verlag). Als reaktive Elemente kommen beispielsweise Hafnium (Hf), Titan (Ti), Zirkonium (Zr), Niob (Nb), Cer (Ce), Tantal (Ta) und Vanadium (V) zum Einsatz. Bei der Metallisierung von Siliziumnitridsubstraten durch Aktivlöten enthält die Reaktionsschicht beispielsweise ein Nitrid, Oxynitrid und/oder Silicid des reaktiven Elements (A. Pönicke et al., "Aktivlöten von Kupfer mit Aluminiumnitrid- und Siliziumnitridkeramik", Keramische Zeitschrift, 63(5), 2011, 334-342).

Die die Halbleiterbauelemente tragende Metallschicht weist eine oder mehrere Aussparungen auf und wird daher auch als strukturierte Metallbeschichtung bezeichnet. Durch die Strukturierung werden beispielsweise metallische Leiterbahnen auf dem Keramiksubstrat ausgebildet. Benachbarte Leiterbahnen sind durch die Aussparungen räumlich getrennt und und daher elektrisch voneinander isoliert. Die Strukturierung von AMB-Substraten kann beispielsweise in einem zweistufigen Verfahren erfolgen, wobei in einem ersten Schritt in definierten Bereichen zunächst die Metallschicht abgetragen wird (z.B. unter Verwendung einer ersten Ätzlösung) und anschließend in einem zweiten Schritt die aus dem Aktivlotverfahren resultierende Haftvermittlungsschicht entfernt wird (z.B. unter Verwendung einer zweiten Ätzlösung). Durch das Abtragen der Metallschicht und gegebenenfalls der Haftvermittlungsschicht wird das Keramiksubstrat in definierten Bereichen wieder freigelegt.

In der Leistungselektronik verwendete Module auf der Basis keramischer Schaltungsträger können im Rahmen des "Packaging" beispielsweise verkapselt werden, indem das Leistungsmodul in eine Vergussmasse eingebettet wird.

Durch die Einbettung in eine Vergussmasse wird beispielsweise die elektrische Durchschlagsfestigkeit erhöht. Außerdem werden die Halbleiterbauelemente und metallischen Leiterbahnen vor Luftfeuchtigkeit geschützt und mechanisch stabilisiert.

In den durch die Strukurierung freigelegten Bereichen kommt das Keramiksubstrat in direkten Kontakt mit der Vergussmasse. Beim Betrieb eines Leistungsmoduls können erhebliche Temperaturschwankungen auftreten. Da keramische Materialien und die Vergussmasse üblicherweise deutlich unterschiedliche Wärmeausdehnungskoeffizienten aufweisen, führen diese Temperaturschwankungen zu mechanischen Spannungen an der Grenzfläche zwischen Keramik und Vergussmasse. Dies wiederum kann dazu führen, dass die Vergussmasse sich zumindest teilweise von dem Keramiksubstrat ablöst und Hohlräume entstehen. Luftfeuchtigkeit, die in diese Hohlräume eindringt, kann das Leistungsmodul schädigen. Außerdem kann es zumindest lokal zu einer signifikanten Reduzierung der elektrischen Durchschlagsfestigkeit kommen.

Wie oben bereits erwähnt, werden Keramiksubstrate auf der Basis von Siliziumnitrid aufgrund ihrer sehr hohen mechanischen Festigkeit bei gleichzeitig hoher Wärmeleitfähigkeit als Schaltungsträger in der Leistungselektronik verwendet. Um ihr Potential als Schaltungsträger möglichst umfassend zu nutzen, wäre es wünschenswert, dass nach einer Einbettung in eine Vergussmasse eine hohe Haftfestigkeit zwischen dieser Vergussmasse und der Siliziumnitridoberfläche vorliegt.

JP 2018-046192 A beschreibt einen Keramik-Metall-Verbund, der in eine polymere Vergussmasse eingebettet wird. Als Keramiksubstrat wird eine Siliziumnitridkeramik verwendet. Freiliegende Bereiche der Keramikoberfläche des Keramik-Metall-Verbunds werden mit einem partikelförmigen Strahlmittel behandelt, so dass in diesen behandelten Bereichen die Keramikoberfläche eine maximale Profilhöhe Ry von 1,7 µm bis 2,7 µm aufweist. Gemäß JP 2018-046192 A soll dies eine gute Haftung der Vergussmasse auf dem Keramiksubstrat bewirken.

Eine Aufgabe der vorliegenden Erfindung ist die Bereitstellung eines metallisierten siliziumnitridhaltigen Keramiksubstrats, dessen freiliegende Keramikoberfläche die Ausbildung einer Verbindung hoher Haftfestigkeit mit einer polymeren Vergussmasse ermöglicht.

Gelöst wird diese Aufgabe durch einen Metall-Keramik-Verbund, enthaltend
- ein Keramiksubstrat, das eine Vorderseite und eine Rückseite aufweist und ein Siliziumnitrid enthält,
- eine auf der Vorderseite des Keramiksubstrats vorliegende Metallbeschichtung, wobei die Metallbeschichtung zumindest eine Aussparung aufweist und eine Oberfläche des Keramiksubstrats durch die Aussparung freigelegt ist,
wobei die durch die Aussparung freigelegte Oberfläche des Keramiksubstrats ein gestrecktes Oberflächenverhältnis S_{dr} gemäß der Norm ILNAS-EN ISO 25178-2:2022 von mindestens 7,0 % aufweist.

Die Rauheit einer Oberfläche kann bekanntermaßen am Profil (d.h. entlag einer Linie) oder auf der Fläche bestimmt werden. Sowohl für die Profilmessung als auch für die Flächenmessung stehen verschiedene Rauheitskennwerte zur Verfügung. In der Norm ISO 4287 werden am Profil bestimmte Rauheitskennwerte wie z.B. die arithmetische mittlere Abweichung Rₐ (auch als arithmetischer Mittenrauwert bezeichnet) oder die maximale Höhe R_{z} des Profils definiert. Auf der Fläche bestimmte Rauheitskennwerte werden in der Normenreihe EN ISO 25178 definiert und beinhalten beispielsweise die arithmetische Durchschnitthöhe Sₐ, die maximale Höhe S_{z} und das gestreckte Oberflächenverhältnis S_{dr}. Anhand der Flächenparameter lässt sich im Vergleich zu den Profilparametern die Rauheit einer Oberfläche wesentlich verlässlicher ermitteln. Für die Bestimmung der Flächenparameter werden beispielsweise optische Messverfahren wie z.B. die Konfokalmikroskopie verwendet.

Das gestreckte Oberflächenverhältnis S_{dr} (englisch: *"Developed Surface Area Ratio*") gemäß ILNAS-EN ISO 25178-2:2022 bezeichnet die Beziehung zwischen einer ideal ebenen Oberfläche zu einer realen Messfläche und ist somit ein Maß für die Rauheit der Oberfläche. Das gestreckte Oberflächenverhältnis S_{dr} ist auch unter dem Begriff "entwickeltes Grenzflächenverhältnis" bekannt und gibt die prozentuale Zunahme der tatsächlichen Oberfläche gegenüber der projizierten (und somit perfekt planaren) Oberfläche an. Wäre also die tatsächliche Oberfläche perfekt planar, so würde S_{dr} 0% betragen. Weist die tatsächliche Oberfläche gegenüber der projizierten Oberfläche beispielsweise eine um den Faktor 2 größere Fläche auf, beträgt S_{dr} 100%. Bei einer Zunahme der Fläche um den Faktor 2,5 beträgt S_{dr} 150%.

Während die Parameter Sₐ und S_{z} reine Höhenkennwerte sind, also nur Informationen in z-Richtung der untersuchten Oberfläche liefern, handelt es sich bei S_{dr} um einen sogenannten Hybridparameter, dessen Wert nicht nur von der Höhe der Oberflächenerhebungen, sondern auch vom Abstand benachbarter Erhebungen abhängt.

Im Rahmen der vorliegenden Erfindung wurde erkannt, dass sich die Haftfestigkeit einer Vergussmasse auf dem Keramiksubstrat verbessern lässt, wenn die freigelegte Oberfläche des Keramiksubstrats ein gestrecktes Oberflächenverhältnis S_{dr} von mindestens 7,0 % aufweist. Die Bestimmung des gestreckten Oberflächenverhältnisses S_{dr} erfolgt durch Konfokalmikroskopie.

Bevorzugt beträgt das gestreckte Oberflächenverhältnis S_{dr} der durch die Aussparung freigelegten Oberfläche des Keramiksubstrats mindestens 9,2 %.

In einer beispielhaften Ausführungsform beträgt das gestreckte Oberflächenverhältnis S_{dr} der durch die Aussparung freigelegten Oberfläche des Keramiksubstrats 7,0 % bis 20,0 %, bevorzugter 9,2 % bis 15,0 %.

Wenn das gestreckte Oberflächenverhältnis S_{dr} einen Wert von mehr als 20% annimmt, erhöht sich das Risiko einer Schädigung des Keramiksubstrats, was sich wiederum nachteilig auf die mechanischen Eigenschaften wie z.B. die Biegebruchfestigkeit des Keramiksubstrats auswirkt.

Die durch die Aussparung freigelegte Oberfläche des Keramiksubstrats weist beispielsweise eine maximale Höhe S_{z} gemäß der Norm ILNAS-EN ISO 25178-2:2022 von 8 µm bis 20 µm, bevorzugter 10 µm bis 15 µm auf. Die Bestimmung der maximalen Höhe S_{z} erfolgt durch Konfokalmikroskopie.

In einer beispielhaften Ausführungsform weist die durch die Aussparung freigelegte Oberfläche des Keramiksubstrats ein gestrecktes Oberflächenverhältnis S_{dr} von 7,0 % bis 20,0 % und eine maximale Höhe S_{z} von 8 µm bis 20 µm, bevorzugter ein gestrecktes Oberflächenverhältnis S_{dr} von 9,2 % bis 15,0 % und eine maximale Höhe S_{z} von 10 µm bis 15 µm auf.

Das Keramiksubstrat enthält Siliziumnitrid. Keramiksubstrate auf der Basis von Siliziumnitrid, die für die Herstellung von Leistungsmodulen geeignet sind, sind dem Fachmann bekannt und kommerziell erhältlich.

Beispielsweise enthält das Keramiksubstrat Siliziumnitrid in einem Anteil von mindestens 70 Gew%, bevorzugter mindestens 80 Gew%.

Optional kann das Keramiksubstrat noch ein oder mehrere Metalloxide enthalten. Diese wurden beispielsweise während der Herstellung des Keramiksubstrats als Sinterhilfsmittel zugegeben. Geeignete oxidische Komponenten für Siliziumnitridkeramiken sind dem Fachmann bekannt. Beispielsweise enthält das Keramiksubstrat eines oder mehrere der folgenden Oxide: Ein oder mehrere Erdalkalimetalloxide wie z.B. Magnesiumoxid, ein oder mehrere Übergangsmetalloxide (z.B. ein oder mehrere Seltenerdoxide wie Yttriumoxid oder Erbiumoxid), ein Siliziumoxid (z.B. SiOz) oder ein Silikat. Das Siliziumnitrid liegt beispielsweise als β-Siliziumnitrid vor.

Das Keramiksubstrat weist beispielsweise eine Dicke im Bereich von 0,1 mm bis 1,0 mm auf.

Auf der Vorderseite des Keramiksubstrats liegt eine Metallbeschichtung vor, die zumindest eine Aussparung aufweist, so dass eine Oberfläche des Keramiksubstrats durch die Aussparung freigelegt ist. Diese Metallbeschichtung wird nachfolgend auch als strukturierte Metallbeschichtung bezeichnet. Auf der strukturierten Metallbeschichtung können die Halbleiterbauelemente angebracht werden.

Optional liegt auf der Rückseite des Keramiksubstrats ebenfalls eine Metallbeschichtung vor. Diese rückseitige Metallbeschichtung kann optional ebenfalls zumindest eine Aussparung, durch die eine Oberfläche des Keramiksubstrats freigelegt ist, aufweisen. Um eine möglichst effiziente Wärmeabführung zu erzielen, kann es bevorzugt sein, dass die rückseitige Metallbeschichtung keine solche Aussparung aufweist.

Die auf der Vorderseite und optional der Rückseite des Keramiksubstrats vorliegende Metallbeschichtung ist beispielsweise eine Kupferbeschichtung oder eine Aluminiumbeschichtung. Die Metallbeschichtung weist beispielsweise eine Dicke im Bereich von 0,05 mm bis 1,5 mm, bevorzugter 0,2 mm bis 0,8 mm auf.

Sofern die Metallbeschichtung eine Kupferbeschichtung ist, weist diese beispielsweise einen Kupfergehalt von mindestens 97 Gew%, bevorzugter mindestens 99 Gew% auf.

Sofern die Metallbeschichtung eine Aluminiumbeschichtung ist, weist diese beispielsweise einen Aluminiumgehalt von mindestens 97 Gew%, bevorzugter mindestens 99 Gew% auf.

Die Metallbeschichtung kann über Verfahren, die dem Fachmann bekannt sind, auf die Vorderseite und gegebenenfalls die Rückseite des Keramiksubstrats aufgebracht werden.

Beispielsweise wird eine Metallfolie (z.B. eine Kupfer- oder Aluminiumfolie) durch ein Aktivlöten stoffschlüssig mit der Vorderseite des Keramiksubstrats verbunden.

Beim Aktivlöten wird beispielsweise bei einer Temperatur von etwa 600-1000°C eine Verbindung zwischen der Metallfolie und dem Keramiksubstrat unter Verwendung eines Aktivlots hergestellt. Aktivlote sind aufgrund ihrer Legierungszusammensetzung in der Lage, nichtmetallische, anorganische Werkstoffe wie z.B. Keramiksubstrate zu benetzen. Neben einer Hauptkomponente wie z.B. Kupfer, Silber und/oder Gold enthalten Aktivlote auch ein oder mehrere Aktivmetalle wie z.B. Hf, Ti, Zr, Nb, V, Ta oder Ce, die mit dem Keramiksubstrat unter Ausbildung einer Reaktionsschicht reagieren können.

Bevorzugt liegt zwischen der Metallbeschichtung und der Vorderseite des Keramiksubstrats eine aus dem Aktivlöten resultierende Reaktionsschicht vor. Die Reaktionsschicht enthält beispielsweise ein oder mehrere Elemente E_{RS}, ausgewählt aus Hf, Ti, Zr, Nb, V, Ta und Ce, bevorzugt ausgewählt aus Hf, Ti, Zr, Nb und Ce, bevorzugter ausgewählt aus Hf, Ti und Zr. Besonders bevorzugt ist das Element E_{RS} in der Reaktionsschicht Titan. Beispielsweise liegen die Elemente E_{RS} in der Reaktionsschicht in Form eines Nitrids, Oxynitrids und/oder Silicids vor. Beispielsweise enthält die Reaktionsschicht die Elemente E_{RS} in einer Gesamtmenge von mindestens 50 Gew%. Beispielsweise enthält die Reaktionsschicht die Nitride, Oxynitride und Silicide der Elemente ESR in einer Gesamtmenge von mindestens 70 Gew%, bevorzugter mindestens 85 Gew%. In einem Halbleitermodul der Leistungselektronik kann die Migration von Silber zu Problemen führen. Es kann daher bevorzugt sein, dass die Reaktionsschicht Silber in einem Anteil von nicht mehr als 5 Gew%, bevorzugter nicht mehr als 1 Gew% enthält oder sogar silberfrei ist.

Das Freilegen einer Oberfläche des Keramiksubstrats erfolgt beispielsweise in mehreren Schritten. Zunächst wird beispielsweise durch ein Ätzen die Metallbeschichtung abgetragen und die beim Aktivlöten gebildete Reaktionsschicht freigelegt. Anschließend wird die freigelegte Reaktionsschicht abgetragen, z.B. durch ein Ätzen oder eine Laserablation. Bevorzugt wird die freigelegte Reaktionsschicht unter Verwendung eines Ultrakurzpulslasers (z.B. eines IR-Picosekunden- oder Femtosekundenlasers) entfernt.

Um die durch die Aussparung voneinander getrennten Bereiche der Metallbeschichtung elektrisch voneinander zu isolieren, wäre es ausreichend, das ein- oder mehrstufige Abtragen nur solange bzw. unter solchen Bedingungen durchzuführen, bis in den behandelten Bereichen die freigelegte Reaktionsschicht vollständig entfernt wurde, ein Abtragen des Keramiksubstrats durch das Abtragungsmedium (z.B. das Ätzmedium oder den gepulsten Laser) jedoch noch nicht stattgefunden hat.

Im Rahmen der vorliegenden Erfindung wird jedoch das Freilegen der Keramiksubstratoberfläche bevorzugt so durchgeführt, dass das Abtragungsmedium (bevorzugt ein Ultrakurzpulslaser, z.B. ein Picosekunden- oder Femtosekundenlaser) nicht nur die freigelegte Reaktionsschicht vollständig entfernt, sondern auch Keramikmaterial abträgt, bis die freigelegte Oberfläche des Keramiksubstrats ein gestrecktes Oberflächenverhältnis S_{dr} von mindestens 7,0 % aufweist.

Eine geeignete Behandlungsdauer und geeignete Parameter des Abtragungsmediums kann der Fachmann durch Versuchsreihen ohne weiteres ermitteln.

Für das Einstellen eines gestreckten Oberflächenverhältnisses S_{dr} im erfindungsgemäßen Bereich hat sich als vorteilhaft erwiesen, wenn der Laserstrahl beim Abtragen der Reaktionsschicht und dem anschließenden Aufrauen der freigelegten Oberfläche des Keramiksubstrats in parallel verlaufenden Scanlinien über die Oberfläche bewegt wird und sich kreuzende Scanlinien möglichst vermieden werden. Die Pulsenergie der Laserpulse wird ausreichend hoch gewählt, um einen Materialabtrag entlang der Scanlinien zu bewirken.

Beispielsweise können mindestens 50%, bevorzugter mindestens 70% der durch die Aussparung freigelegten Oberfläche des Keramiksubstrats oder kann sogar im Wesentlichen die gesamte durch die Aussparung freigelegte Oberfläche des Keramiksubstrats das erfindungsgemäße gestreckte Oberflächenverhältnis S_{dr} und optional die oben angegebene maximale Höhe S_{z} aufweisen.

Eine freigelegte Oberfläche des Keramiksubstrats, die ein gestrecktes Oberflächenverhältnis S_{dr} von mindestens 7,0 % aufweist, führt zu einer verbesserten Haftfestigkeit einer Vergussmasse auf dem Keramiksubstrat.

Die vorliegende Erfindung betrifft außerdem ein Halbleitermodul, enthaltend
den oben beschriebenen Metall-Keramik-Verbund und
ein oder mehrere Halbleiterbauelemente.

Bevorzugt enthält das Halbleitermodul außerdem eine Vergussmasse, wobei die Vergussmasse die durch die Aussparung freigelegte Oberfläche des Keramiksubstrats des Metall-Keramik-Verbunds kontaktiert.

Vergussmassen für elektronische Bauelemente sind dem Fachmann bekannt. Die Vergussmasse enthält beispielsweise ein Polymer (z.B. ein thermoplastisches oder duroplastisches Polymer). Beispielsweise enthält die Vergussmasse ein optional ausgehärtetes Epoxidharz oder Silikonharz, ein Polyurethan oder einen anorganischen Zement (z.B. einen Phosphatzement).

### Messmethoden

### Bestimmung des gestreckten Oberflächenverhältnisses S_{dr} und der maximalen Höhe S_{z}

Zur Bestimmung des gestreckten Oberflächenverhältnisses S_{dr} und der maximalen Höhe S_{z} wurden unter Verwendung des Konfokalmikroskops µsurf custom (NanoFocus AG, Deutschland) 3D-Aufnahmen der Keramiksubstratoberfläche angefertigt, die mindestens 800 µm x 800 µm der freigelegten Oberfläche des Keramiksubstrats abbildeten. Mittels der Software µSoft Analysis Premium (7.4.8872; NanoFocus AG, Deutschland) wurden die mikroskopischen 3D-Aufnahmen ausgewertet. Hierzu wurde zunächst eine eventuelle Durchbiegung des Bondsubstrats in den 3D-Aufnahmen korrigiert (Verwendung eines Polynoms von Grad 2). Danach wurden das gestreckte Oberflächenverhältnis S_{dr} und die maximale Höhe S_{z} gemäß der Norm ILNAS-EN ISO 25178-2:2022 bestimmt.

### Zusammensetzung der Haftvermittlungsschicht

Die Zusammensetzung der Haftvermittlungsschicht wird durch eine energiedispersive Röntgenspektroskopie (EDX), gekoppelt mit Rasterelektronenmikroskopie, bestimmt (REM-EDX).

Bei REM-EDX wird ein fokussierter Primär-Elektronenstrahl punktweise über die Probenoberfläche geführt (gerastert). Die gestreuten Elektronen werden mit einem Detektor erfasst, wobei die Elektronenzahl pro Bildpunkt ein mikroskopisches Abbild der Probenoberfläche in Graustufen ergibt. Zusätzlich regt der Primär-Elektronenstrahl die Probe zur Emission von charakteristischer Röntgenstrahlung an, wobei die Elemente in der Probe und deren Gewichtsanteil durch die Analyse des Energiespektrums mit einem EDX-Detektor bestimmt werden kann. Für die Untersuchung wird beispielsweise ein RasterElektronenmikroskop (JSM-6060 SEM, JEOL Ltd) mit einem Silizium Drift EDX Detektor (NORAN, Thermo Scientific Inc) und einer Analysesoftware (Pathfinder Mountaineer EDS System, zum Beispiel Version 2.8, Thermo Scientific Inc) verwendet. Für die RasterElektronenmikroskopie werden folgende Einstellungen verwendet: Vergrößerung: 1000fach, Beschleunigungsspannung = 15 kV, Arbeitsabstand = 10 mm, Spotgröße (50 - 60) (eingestellt, um 25% +/- 5% der Totzeit des EDX-Detektors zu erreichen). Das EDX-Spektrum wurde unter Verwendung der folgenden Einstellungen des EDX-Detektors erfasst: Live Time = 30 s, Rate = auto, Low Energy Cutoff = 100 keV, High Energy Cutoff = Auto (per REM-Beschleunigungsspannung).

Durch REM-EDX lässt sich die Zusammensetzung der Haftvermittlungsschicht sowohl in qualitativer Hinsicht (Detektion bestimmter Elemente und Phasen, z.B. eine in der Haftvermittlungsschicht vorliegende Metallnitridphase) als auch quantitativ bestimmen. Die Messung wird beispielsweise an mindestens 10 Stellen der Haftvermittlungsschicht durchgeführt.

### Beispiele

Aus einem Siliziumnitrid-Ausgangssubstrat, das Sollbruchstellen für eine Vereinzelung aufwies, wurden vier Siliziumnitrid-Einzelsubstrate abgetrennt. Die Keramiksubstrate S1-S4 wiesen übereinstimmende Abmessungen (174 mm x 139 mm x 0,32 mm) auf.

Für jedes der Siliziumnitrid-Einzelsubstrate wurden in dem Bereich der Vorderseite, der später nach der erfolgten Metallisierung wieder freigelegt wird, S_{z} und S_{dr} bestimmt. Die Substrate wiesen im Wesentlichen übereinstimmende S_{dr}-Werte auf. Auch in ihren S_{z}-Werten stimmten die Keramiksubstrate im Wesentlichen überein.
S_{dr} der Ausgangssubstrate: 5,0 % +/- 0,5 %
S_{z}: 5,9 +/- 0,9 µm

Die Siliziumnitridsubstrate wurden durch identische Aktivlotverfahren unter den nachfolgend beschriebenen Bedingungen metallisiert.

Auf einer der Seiten des Keramiksubstrats wurde auf einer Fläche der Abmessung 168 mm x 130 mm eine Aktivlotpaste durch Siebdruck aufgebracht und für 15 Minuten bei 125°C vorgetrocknet. Die Aktivlotpaste bestand aus 67 Gewichtsprozent Kupferpulver, 19,8 Gewichtsprozent Zinnpulver und 3,7 Gewichtsprozent Titanhydrid und 9,5 Gewichtsprozent eines organischen Vehikels. Die Pastendicke nach der Vortrocknung betrug 25 +/- 5 µm. Anschließend wurde eine Kupferfolie aus sauerstofffreiem, hochleitfähigem Kupfer mit einer Reinheit von 99,99% und einer Abmessung von 170 mm x 132 mm x 0.3 mm auf die vorgetrocknete Paste gelegt. Danach wurde die so erzeugte Anordnung herumgedreht, die Paste gleichermaßen auf die gegenüberliegende Seite des Keramiksubstrats durch Siebdruck aufgebracht, vorgetrocknet und mit einer Kupferfolie bestückt, um eine Sandwichanordnung zu erhalten. Die Sandwichanordnung wurde mit einem Gewicht von 1 kg beschwert, bei einer Höchsttemperatur von 910°C für 20 Minuten gebrannt und anschließend auf Raumtemperatur abgekühlt, um einen unstrukturierten Metall-Keramik-Verbund zu erhalten. Aufgrund der Herstellung durch ein Aktivlöten liegt zwischen der Metallbeschichtung und dem Keramiksubstrat eine haftvermittelnde Reaktionsschicht vor. Diese enthält Titan (z.B. in Form eines Nitrids).

Jeder der drei Metall-Keramik-Verbunde wurde einer ersten Strukturierung unter Verwendung einer CuCl₂-haltigen Ätzlösung unterzogen. Dabei wurde auf der Vorderseite des Keramiksubstrats die Metallbeschichtung in den geätzten Bereichen im Wesentlichen vollständig abgetragen. Die aus dem Aktivlotverfahren resultierende Reaktionsschicht wurde allerdings durch die CuCl₂-haltige Ätzlösung nicht entfernt.

In Vergleichsbeispiel VB1 wurde die freigelegte Reaktionsschicht mit einer Ätzlösung, die Ammoniumfluorid, Fluorborsäure sowie Wasserstoffperoxid enthielt, entfernt.

In den erfindungsgemäßen Beispielen EB1 und EB2 sowie dem Vergleichsbeispiel VB2 wurde die freigelegte Haftvermittlungsschicht durch eine Laserbehandlung mit einem gepulsten Laserstrahl entfernt. In Vergleichsbeispiel VB2 wurde ein Laserstrahl mit einer relativ niedrigen Pulsenergie verwendet, so dass nur ein geringer Materialabtrag stattfand. In den erfindungsgemäßen Beispielen EB1 und EB2 wurde dieselbe Pulsenergie verwendet, die gegenüber der im Vergleichsbeispiel VB1 verwendeten Pulsenergie erhöht war und daher zu einem höheren Materialabtrag führte. In EB1 wurde der Laserstrahl auf sich kreuzenden Scanlinien geführt, während in EB2 der Laser auf parallel verlaufenden Scanlinien geführt wurde.

Für die freigelegten Keramikoberflächen der erfindungsgemäßen Beispiele EB1 und EB2 sowie der Vergleichsbeispiele VB1 und VB2 wurde jeweils das gestreckte Oberflächenverhältnis S_{dr} und die maximale Höhe Sz gemessen. Anschließend wurde auf jede der freigelegten Keramikoberflächen eine Vergussmasse aufgebracht und die Haftfestigkeit bestimmt.

### Die Bestimmung der Haftfestigkeit erfolgte folgendermaßen:

Für die Bestimmung der Haftung einer Vergussmasse (Silikon) wurden aus jedem der freigelegten Bereiche des jeweiligen Keramiksubstrats zwei Plättchen (Größe der Plättchen: 20 x 20 x 0.32 mm) herausgeschnitten. Anschließend wurden die zwei Plättchen, die demselben Keramiksubstrat entnommen wurden, zu einem Prüfkörper mittels Silikons von Typ Sylgard 527 verklebt. Der Überlapp beider Plättchen betrug 1 cm, so dass die haftende Oberfläche immer 2cm² aufwies. Das Silikon wurde für 2h bei 125°C an Luft ausgehärtet. Jede Prüfkörper wurde dabei mit 50g Gewicht zusammengedrückt, um eine gleichmäßig dünne Silikonschicht zu erzeugen.

Die so hergestellten Prüfkörper wurden auf Scherfestigkeit getestet (Prüfmaschine: Modell zwicki500, ZwickRoell GmbH & Co. KG). Es wurde jeweils die maximale Scherkraft bestimmt.

In der folgenden Tabelle 1 sind die Ergebnisse zusammengefasst.

**Tabelle 1: S_{dr}- und S_{z}-Werte der freigelegten Keramikoberflächen und Haftfestigkeiten zwischen den freigelegten Keramikoberflächen und einer Vergussmasse**

| Beispiel | S_{dr} (%) | S_{z} (µm) | Haftfestigkeit (N) |
|---|---|---|---|
| VB1 | 5,2 | 6,1 | 3,4 |
| VB2 | 6,05 | 7,35 | 5,2 |
| EB1 | 8,25 | 14,1 | 15,5 |
| EB2 | 9,71 | 13,7 | 25,1 |

Die Beispiele belegen, dass eine signifikante Verbesserung der Haftfestigkeit der Vergussmasse auf der freigelegten Keramikoberfläche erzielt wird, wenn das gestreckte Oberflächenverhältnis S_{dr} im erfindungsgemäßen Bereich liegt.

## Patentansprüche

1. Ein Metall-Keramik-Verbund, enthaltend
ein Keramiksubstrat, das eine Vorderseite und eine Rückseite aufweist und ein Siliziumnitrid enthält,
eine auf der Vorderseite des Keramiksubstrats vorliegende Metallbeschichtung, wobei die Metallbeschichtung zumindest eine Aussparung aufweist und eine Oberfläche des Keramiksubstrats durch die Aussparung freigelegt ist,
wobei die durch die Aussparung freigelegte Oberfläche des Keramiksubstrats ein gestrecktes Oberflächenverhältnis S_{dr} gemäß der Norm ILNAS-EN ISO 25178-2:2022 von mindestens 7,0 % aufweist, wobei S_{dr} durch Konfokalmikroskopie bestimmt wird.

2. Der Metall-Keramik-Verbund nach Anspruch 1, wobei das gestreckte Oberflächenverhältnis S_{dr} der durch die Aussparung freigelegten Oberfläche des Keramiksubstrats 7,0 % bis 20,0 %, bevorzugter 9,2 % bis 15,0 % beträgt.

3. Der Metall-Keramik-Verbund nach Anspruch 1 oder 2, wobei die durch die Aussparung freigelegte Oberfläche des Keramiksubstrats eine maximale Höhe S_{z} gemäß der Norm ILNAS-EN ISO 25178-2:2022 von 8 µm bis 20 µm aufweist, wobei S_{z} durch Konfokalmikroskopie bestimmt wird.

4. Der Metall-Keramik-Verbund nach einem der vorstehenden Ansprüche, wobei die Metallbeschichtung eine Kupfer- oder Aluminiumbeschichtung ist.

5. Der Metall-Keramikverbund nach einem der vorstehenden Ansprüche, wobei zwischen dem Keramiksubstrat und der Metallbeschichtung eine Reaktionsschicht vorliegt, wobei die Reaktionsschicht ein oder mehrere Elemente E_{RS}, ausgewählt aus Ti, Hf, Zr, Nb, V, Ta und Ce, enthält.

6. Ein Halbleitermodul, enthaltend
den Metall-Keramik-Verbund gemäß einem der Ansprüche 1-5,
ein oder mehrere Halbleiterbauelemente.

7. Das Halbleitermodul nach Anspruch 6, außerdem enthaltend eine Vergussmasse, wobei die Vergussmasse die durch die Aussparung freigelegte Oberfläche des Keramiksubstrats des Metall-Keramik-Verbunds kontaktiert.
